# EUROPEAN PATENT SPECIFICATION

(11) **EP 4 497 151 B1**
(45) Date of publication and mention of the grant of the patent: **29.04.2026**
(21) Application number: 22817719.2
(22) Date of filing: 15.11.2022
(51) Int. Cl.: H10N 30/072, H01L 21/20, H01L 21/762, H01L 21/02, H03H 3/08, H03H 9/02

(54) **METHOD OF FORMING A COMPOSITE SUBSTRATE**
VERFAHREN ZUR HERSTELLUNG EINES VERBUNDSUBSTRATS
PROCÉDÉ DE FORMATION D'UN SUBSTRAT COMPOSITE

(30) Priority: 23.03.2022 DE 102022106877
(43) Date of publication of application: 29.01.2025
(73) Proprietor: Czigler, Zoltan, 6300 Zug (CH)
(72) Inventor: RAZEK, Nasser, 3006 Bern (CH); SCHINDLER, Axel, 04668 Grimma (DE)
(74) Representative: Viering, Jentschura & Partner mbB Patent- und Rechtsanwälte
(86) International application number: PCT/EP2022/081950
(87) International publication number: WO 2023/179898

(56) References cited:
- CN-A- 109 166 793
- US-A1- 2021 108 338
- US-B2- 10 727 396

## Description

This disclosure generally relates to the field of forming of composite substrates including a wafer bonding process.

A surface acoustic wave (SAW) device, a device in which a supporting substrate and a piezoelectric substrate that propagates a surface acoustic wave are bonded together is known. By sticking a support substrate with a smaller thermal expansion coefficient than the piezoelectric substrate in this way, the change in size of the piezoelectric substrate when the temperature changes is suppressed, and the change of the frequency characteristics of the surface acoustic wave device are reduced is known. WO2017163722A1 discloses a surface acoustic wave device having a structure in which a piezoelectric substrate and a silicon substrate are bonded together using a multi-step procedure where in a first step a so called bonding layer out of a group of different specified materials is deposited at least onto one of the bonding partners and in a second step this layer and the surface of the other bonding partner are activated by a plasma process followed by a direct bonding step and after it by a thermal annealing.

CN109786229B discloses a surface acoustic wave device in which the bonding of piezoelectric wafers with different substrate materials for limited wafer sizes from 0.051 m to 0,102 m by using a wet chemical wafer bonding surface procedure followed by an Ar/O₂ mixed gas plasma activation.

CN109166793B discloses a two-step surface activation prior to a direct bonding step.

Here, a first activation step is: placing a lithium niobate wafer and a silicon wafer to be bonded under a vacuum ultraviolet light source and activating under the humidity condition of 20-80%. A second activation step is: placing the wafer activated by vacuum ultraviolet light in N₂-plasma under the pressure of 10 - 80 Pa.

US10727396B2 discloses possibility to utilize oxygen gas in a plasma activation step prior a direct bonding step.

US2021108338 A1 discloses the use of UV light for surface activation of a piezoelectric substrate prior a bonding step.

Known wafer bonding methods of piezoelectric material onto supporting wafers often show one or more of the following technical problems and/or problems of the finally produced radio frequency filter devices, respectively: passbands shift of SAW-device with temperature, of substrates during annealing and thinning process, thermal micro-voids (e.g. outgassing), breaking high electrostatic charge (e.g. warping and high bow) and not sufficient bonding strength for further processing of the bonded wafer pair (e.g. thinning, dicing), and increasing SAW propagation loss.

It is an object of the invention to provide a method to form a composite substrate including a wafer bonding process having an improved performance.

The method to form a composite substrate may include features of claim 1. Further embodiments are laid out in the dependent claims. The method provides an efficient fabrication of thin film surface acoustic wave (also denoted as TF-SAW) and other related devices by forming a stable bonding of a piezoelectric wafer with a supporting wafer efficiently.

Illustratively, the method considers process flows to improve a wafer bonding of piezoelectric crystals onto supporting wafer materials, which appear in known wafer bonding processes and manufacturing of SAW devices. For example, the following characteristics may be improved by the method: passbands shift of SAW-device with temperature, of substrates during annealing and thinning process, thermal micro-voids (e.g. outgassing), breaking high electrostatic charge (e.g. warping and high bow) and not sufficient bonding strength for further processing of the bonded wafer pair (e.g. thinning, dicing), and SAW propagation loss. This way, a piezoelectric material with a large electromechanical coupling coefficient and excellent stability with temperature may be provided

In the drawings, like reference characters generally refer to the same parts throughout the different views. The drawings are not necessarily to scale, emphasis instead generally being placed upon illustrating the principles of the invention. In the following description, various aspects of the invention are described with reference to the following drawings, in which:
**FIG. 1** illustrates a schematic cross-sectional view of a composite substrate.
**FIG. 2** illustrates a flow diagram of a method to produce a composite substrate.
**FIG. 3A to FIG. 3F** show schematic illustrations views of the method to produce a composite substrate.
**FIG. 4** illustrates a schematic plasma system for the method to produce the composite substrate.
**FIG. 5A to FIG. 5D** show atomic force microscopy images of surfaces of substrates composing the composite substrate.
**FIG. 6** to **FIG. 10** B show surface acoustic microscopy images (SAM) and Infrared transmission images (IR) of surfaces of substrates composing the composite substrate
**FIG.11** **A** to **FIG.12** **B** show schematic cross-sectional views of composite substrates in a substrate thinning process.

The following detailed description refers to the accompanying drawings that show, by way of illustration, specific details and aspects in which the invention may be practiced.

The scope of the invention is defined by the appended claims.

According to the invention, a method is described providing a wafer bonding of piezoelectric materials onto a supporting substrate produced using mixed gas plasma activation. The method includes a mixed gas plasma of oxygen (O₂) and nitrogen (N₂) activation, a mixed gas of O₂ and N₂ including ultraviolet light (UV)-surface modification, e.g. by using an excimer lamp, a bonding process in low vacuum, and thermal annealing at low temperatures less than 200 °C.

This method achieves a high bond quality for piezoelectric substrates like lithium tantalate (LT) and lithium niobate (LN) onto silicon (Si), silicon oxide, silicon carbide (SiC), cubic boron nitride (c-BN,) and diamond. The resulting bonded materials (also denoted as composite substrate) may be free or substantially free from macroscopic voids and microscopic voids across a bond interface. Alternatively, or in addition, the composite substrate may be free of creaking and warping of bonded wafers. An initial pre-bond state (also denoted as precursor composite substrate) may show a higher bond strength than using known bonding techniques. The composite structure may be used for achieving thin film surface acoustic wave (also denoted as TF-SAW) device for various applications, e.g. as a filtering device in communication, or a pump or mixing device in fluid-handling device.

Piezoelectric materials from materials group such as lithium tantalate (LT), lithium niobate (LN) have large electromechanical coupling coefficients that are advantageous in achieving broadband filter characteristics. However, these materials have a drawback of having poor stability with temperature. The method provides a permanent wafer direct bonding method (also denoted as fusion bonding) by using a mixed gas plasma activation process and UV-surface modification to provide a composite substrate having a strong bonding (also denoted as cohesion composite substrate) or strong adhesion between the wafer and piezoelectric material. The composite substrate may be free of micro-voids at bond interfaces for different materials combinations: such as LT//Si, LN//Si, LN//SiO₂, LT//SiO₂, quartz//Si, LN/SiC, LT//SiC, LN//BN, LT//BN, LT//diamond and LN//diamond.

The method may be configured so that the plasma activating process with the UV modification process forms an intermediate film (also denoted as bond layer) at a predetermined level. The characteristics of intermediate film may be controlled by parameters of the plasma activation process and parameters of the UV modification process having effect on the bonding surfaces of the piezoelectric substrate and the supporting substrate. The bond layer may include the same constituents from the plasma gases used, e.g. oxygen and nitrogen, and the materials of the two substrates to be bonded, e.g. a wafer and a piezoelectric material wafer.

The intermediate layer may include one or more amorphous oxides and one or more amorphous nitrides. An amorphous oxide may improve the bond quality, and an amorphous nitride may improve the bond strength.

The plasma activation process and mixed gas UV-surface modification process can be configured to remove impurities and organic contaminants from the surfaces of the substrates to clean the surfaces to be bonded. This improves the bond quality and bond strength between the piezoelectric substrate and the supporting substrate at low temperature.

The bonding process may be carried out in low vacuum preferable up to 0.1 Pa. This way, a residual of a water film from both substrate surfaces is removed.

Illustratively, the bonding process is a direct wafer bonding of different material combinations. This way, efficient bonding with high bonding strength of Si//Si, Si//SiO₂, LT//Si-dioxide, LT//Si, LT//Quartz, and LT//Sapphire (Al₂O₃) can be achieved at room temperature through material related optimization of plasma activation parameters. Plasma activation parameters may include plasma power, plasma gas pressure, plasma duration, the ratio of gas flows (N₂ to O₂), pre-bonding process conditions (e.g. vacuum ambient and mechanical pressure), and mixed gas UV-surface modification and a (post-)thermal annealing process.

The method provides a surface activation using a gas mixture of O₂ and N₂ for plasma surface activation and mixed gas UV-surface modification of both wafers to be bonded, e.g. a piezoelectric wafer (also denoted as second substrate) and a supporting substrate wafer (also denoted as first substrate).

The first substrate (supporting substrate) includes or is formed of, e.g., silicon (Si), silicon oxide (SiO₂), sapphire (Al₂O₃), silicon carbide (SiC), cubic boron nitride (c-BN) and diamond. The second substrate (piezoelectric substrate) includes or is formed of, e.g., lithium niobate (LN), lithium tantalate (LT), and Quartz (SiO₂). The first substrate is directly bonded to the second substrate after the plasma activation process and the UV-modification process. The mixed gas plasma surface activation process with the mixed gas UV-radiation modification process may bond piezoelectric lithium niobate (LN) surfaces or piezoelectric lithium tantalate (LT) surfaces to supporting substrates. The bonding process may be used to bond dissimilar materials of LN- wafer or LT-wafers to any one of Si, SiO₂, c-BN, SiC and diamond-wafers at room temperature in vacuum ambient condition.

The plasma activation process may be performed in a plasma chamber having enclosed in a housing a first electrode and a second electrode with an adjustable gas flow between the first electrode and the second electrode. The power at the first electrode and the second electrode may be adjusted independently (also denoted as separated) from each other. An electrical potential between the first electrode and the second electrode may form a plasma from the gas molecules flowing between the first electrode and the second electrode. Hence, the electrical power provided to the first electrode and the second electrode may also be denoted as plasma power. The plasma power for the first electrode, which may be a top electrode of the plasma chamber, may be in the range from 10 W to 150 W, for example. The plasma power for the second electrode, which may be a bottom electrode of the plasma chamber, may be in the range from 10 W to 75 W, for example.

The processing times of the plasma activation process (also denoted as plasma active time) of the first substrate and/or second substrate may be in the range from about 5 seconds (s) to about 180 s, e.g. in the range from about 10 s to about 120 s, respectively.

The plasma working pressure of the plasma activation process of the first substrate and/or second substrate may be in the range from about 10 Pa to about 300 Pa, e.g. in the range from about 20 Pa to about 100 Pa, respectively.

A thermal annealing of the bonded precursor composite substrate may be performed under forming gas atmospheric at a temperature in a temperature range from about 80 °C to about 190 °C, e.g. in a temperature range from about 100 °C to about 175 °C.

The direct covalent bonding between the crystalline piezoelectric material of the second substrate and the material of the first substrate can achieve adjustable bond strengths in a range from about 0.5 J/m² to about 2.5 J/m², e.g. 0.5 J/m², 0.8 J/m², 1.0 J/m², 1.2 J/m², 1.5 J/m², 1.8 J/m², or 2.0 J/m².

The composite substrate may be one of various material combinations having covalently bonded and having a high bonding strength of, e.g., LT//Si, LT//SiO₂, LT//SiC, LT//c-BN, and LT//diamond, LN//Si, LN//SiO₂, LN//SiC, LN//c-BN, and LN//diamond or any combination thereof.

The bonding interface of the composite substrate may be a high-quality bond, e.g. the interface may be free of micro-voids, without outgassing, and without damage of surfaces structures.

The bonding interface of the composite substrate may have an excellent thermal stability against high temperature up to 200 °C.

The method may allow bonding first and second substrates of various commercially available wafer formats, e.g. supporting wafer sizes of 0.051 m, 0.102 m, 0.153 m and 0.204 m, or even larger.

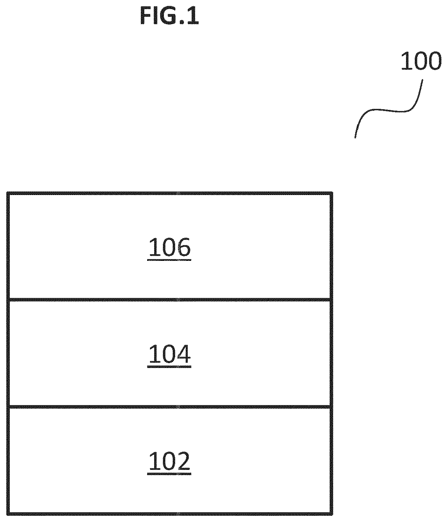

FIG. 1 illustrates a schematic cross-sectional view of a composite substrate 100 including a first substrate 102 bonded to a second substrate 106 via a bonding layer 104. The second substrate 106 may include or may be formed of a piezoelectric material as stated above. The first substrate 102 and the second substrate 106 are directly bonded. Thus, the bonding layer 104 may include a combination of the materials of the first substrate, the second substrate 106, oxygen and/or nitrogen.

Illustratively, the bonding layer 104 may be divided into oxide amorphous domain(s), nitride amorphous domain(s), and metal amorphous domain(s) in directly bonded interface(s) and sub-bond interface(s).

The composite substrate 100 may be used to form a TF-SAW device, for example.

The method to form the composite substrate 100 can be improved or even optimized by varying the plasma conditions: plasma power, plasma duration, gas pressure of the plasma being lower than 200 Pa, mixed gas flow rate and the ratio of both gases flows and exposure to UV light (e.g. in a range of about 150 nm -500 nm) with low power under mixed gas (O₂ + N₂) atmosphere.

The composite substrate 100 of various material combinations includes high bond strength, no or substantially no thermal outgassing, and low electrostatic charge (e.g. a bow of the composite substrate 100 may be smaller than 20 µm), and no breaking of bonded first and second substrates during a thermal annealing for temperatures up to 200 °C and during an optional mechanical thinning of the of LT/LN bonded wafer part from about 250 µm to about 2 µm film thickness without any damage for different wafer sizes, e.g. up to 0.153 m wafers for the first substrate 102 and second substrate 106.

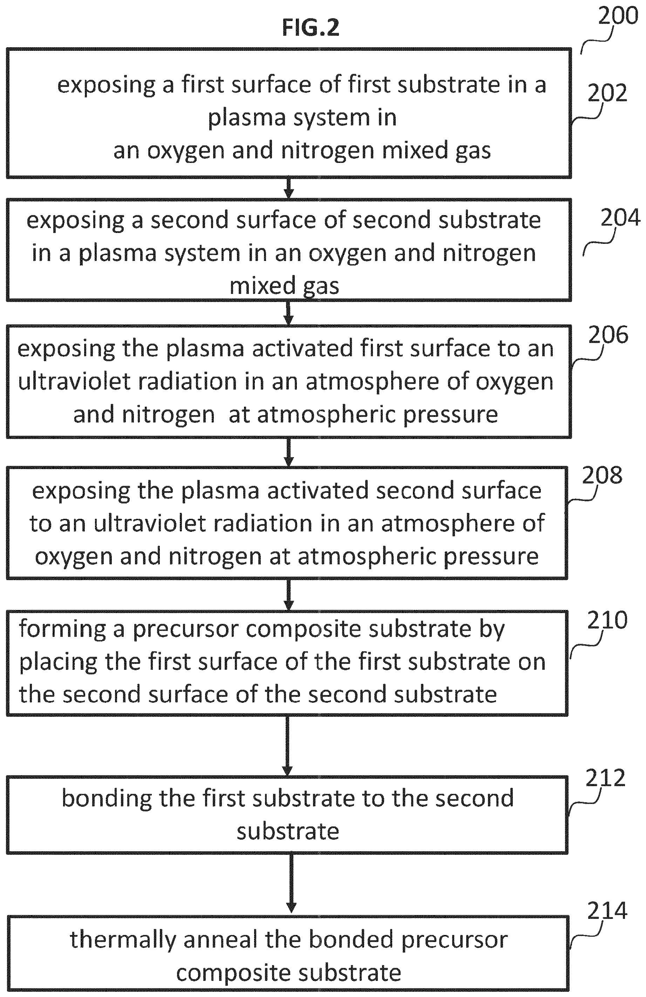

**FIG.** 2 shows a flow diagram of a method 200 for forming a composite substrate 100 illustrated in **FIG.** 1. The method 200 may include a plasma activation process 202 including exposing a first surface of first substrate in a plasma system. The plasma is a mixed gas plasma of oxygen and nitrogen at a first ambient pressure. The first ambient pressure may be below an atmospheric pressure.

The method 200 may include a plasma activation process 204 including exposing a second surface of a second substrate. The plasma system may be a radiofrequency system (e.g. a plasma chamber including radio frequency or microwave generators to generate a gas plasma from a gas flowing through the plasma chamber) having a plasma between a first electrode and a second electrode. The first electrode and the second electrode may be configured to be separately powered and controlled. The plasma is a mixed gas plasma of oxygen and nitrogen at a first ambient pressure. The first ambient pressure may be below an atmospheric pressure.

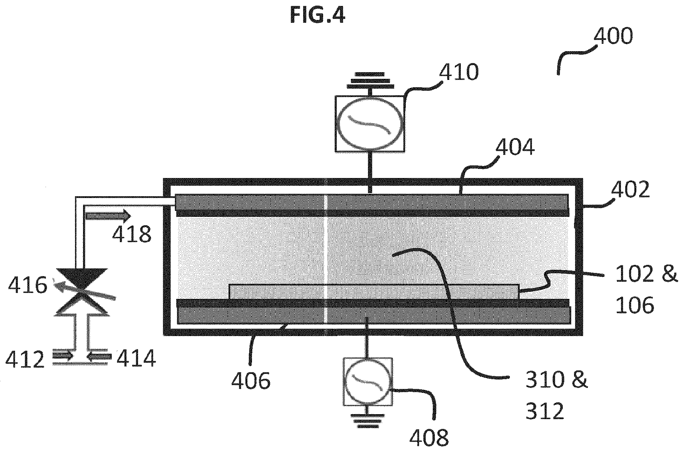

The plasma system is illustrated in **FIG.4** in more detail.

The method 200 may further include a surface modification process including exposing the plasma activated first surface 206 to an ultraviolet radiation in an atmosphere of oxygen and nitrogen at atmospheric pressure. The method 200 may further include a surface modification process including exposing 208 the plasma activated second surface 208 to an ultraviolet radiation in an atmosphere of oxygen and nitrogen at atmospheric pressure.

The method 200 may further include a process 210 of forming a precursor composite substrate by placing the first surface of the first substrate on the second surface of the second substrate.

The method 200 may further include a process 212 of bonding the first substrate to the second substrate by applying a mechanical load on the precursor composite substrate at a second ambient pressure.

The method may further include a process 214 of thermally annealing the bonded precursor composite substrate.

Here, the first substrate is a wafer configured to support the second substrate that is single crystal and non-crystal. The second substrate is a piezoelectric material wafer.

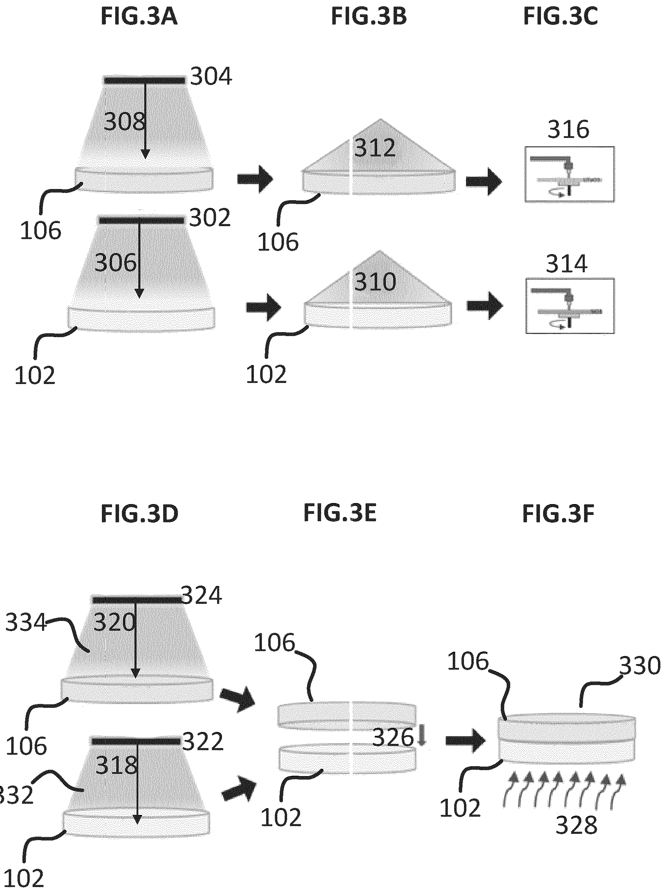

**FIG. 3A to FIG. 3F** show schematic illustrations views of the method of **FIG.2** to produce a composite substrate. Illustratively, the method includes a general process flow for direct wafer bonding of the second substrate 106 to the first substrate 102. The method generally may include the following processes: exposing the first substrate 102 and the second substrate 106 to excimer light 306, 308 emitted by excimer lamp(s) 302, 304 in atmospheric air ambient, as illustrated in FIG. 3A. An excimer lamp 302, 304 may provide electromagnetic radiation (also denoted as light) having a wavelength or wavelength spectrum in the wavelength range from about 150 nm to about 500 nm (also denoted as ultraviolet (UV) light). The excimer light 306, 308 may be the same or different for the first substrate 102 and the second substrate 106. Thus, organic contaminations and non-organic contaminations may be reduced or even removed.

**FIG. 3B** illustrates that the first substrate 102 may be exposed to mixed gas plasma activation 310 at room temperature, and the second substrate 106 may be exposed to mixed gas plasma activation 312 at room temperature. This way, the surface species of the material of the first substrate and the material of the second substrate may be reduced, respectively, and the bonding layer 104 may be formed on the first surface and the second surface.

The method may include rinsing processes 314, 316 of the plasma activated first substrate 102 and the plasma activated second substrate 106, as illustrated in FIG. 3C. The rinsing processes 314, 316 may include megasonic assisted deionized (DI) water rinsing and drying of the rinsed first substrate and rinsed second substrate. This way, particles and organic contaminations may be removed from the first surface and from the second surface.

In other words, after surface activation, the first substrate 102 and the second substrate 106 may be cleaned by using a megasonic cleaning nozzle (here, megasonic may correspond to acoustic signals having a frequency in the range between 700 kHz and 5 MHz) and a DI-water cleaning nozzle, e.g. subsequently in this order. The cleaned substrate 102, 106 may be placed in a spinner. The spinner may spin the cleaned substrate to dry the substrate. The cleaning by using a megasonic cleaning nozzle, a DI-water cleaning nozzle and a spinner may be integrated in a single-wafer cleaner system.

The surface modification process of the method, illustrated in FIG. 3D, may include exposing the first substrate 102 and the second substrate 106 to light 318, 320 emitted by one or more excimer lamp(s) 322, 324. The excimer light 318, 320 may be the same or different for the first substrate 102 and the second substrate 106. The first surface of the first substrate 102 and the second surface of the second substrate 106 may be exposed to a mixture of radicals and other reactive atomic or molecular particles, 334 of N₂ and O₂ during the UV light exposition. The mixtures 332, 334 may be the same or different for the first substrate 102 and the second substrate 106. The first surface of the first substrate 102 and the second surface of the second substrate 106 may be exposed to a low temperature (e.g. less than 100 °C) during the UV light exposition. This way, any contaminations may be removed from the first surface and the second surface. Further, the surface energy and polarity of the first surface and the second surface may be adjusted for a chemical reaction on the atomic or molecular level. This way, functional groups on dangling bonds are enhanced. Thus, bond strength at room temperature may be improved.

The process of forming a precursor composite substrate 330 may include a mechanical alignment, e.g. flat to flat, or notch to notch of the first surface to second surface, as illustrated in FIG. 3E. The bonding process may be performed in vacuum ambient at a processing gas pressure lower than 0.1 Pa at room temperature. The bonding process may be performed under mechanical pressure of up to 5 kN. The mechanical pressure is oriented to compress the first substrate and the second substrate. In other words, the mechanical pressure is oriented to press the first substrate into the second substrate, or vice versa.

In other words, in the process of forming a precursor composite substrate, the first substrate 102 with its first surface and the second substrate 106 with its second surface may be placed face to face with mechanical alignment 326 (e.g. wafer flat of first substrate to wafer flat of second substrate) in a standard wafer-bonder system. The standard wafer-bonder system may utilize mechanical force pressure of up to 5 kN in vacuum ambient of nearly 0.1 Pa. Thus, van der Waals forces pull the first substrate and the second substrate into contact to get bond strength at room temperature of up to 0.8 J/m². Thermal annealing for preselected temperature(s) between 100 °C to 190 °C for several hours may be applied to improve the bond strength larger than 1.2 J/m².

The process of thermally annealing 328 (also denoted as post thermal annealing) can be performed in an as-such standard forming gas ambient furnace and/or on a hot plate in one or more temperature periods at one or more temperature(s) of up to 200 °C - illustrated in **FIG. 3F****.** This way, bond strength, e.g. cohesion of the bond layer 104 (see **FIG.** 1), can be improved.

The surface modification process including the ambient UV light exposure may be an additional process applied to clean the first surface and the second surface from most of organic contaminations. The UV light exposure may include excimer light having a wavelength below 400 nm, for example.

The UV light exposure may be performed under normal air atmosphere. UV light exposure may be capable of breaking or configured to break molecular bonds of organic matter. This way, UV light exposure may reduce various hydrocarbons at the first surface and/or second surface, e.g. before plasma activation.

**FIG.** 4 illustrates a schematic view of a double RF-capacitive coupled plasma system 400 that may be used for the mixed gas plasma activation of wafer surfaces.

The plasma system 400 may have a conventional horizontal capacitive parallel double electrode including a first electrode 404 and a second electrode 406. The first electrode 404 and the second electrode 406 may be separately powered and/or controlled by one or more RF-power supplies 408 and 410 and one or more controllers (not shown). The RF-power supplies 408 and 410 may provide RF-power with different frequencies in the kHz range to the electrodes 404, 406. The plasma power may be in the range from about 10 W to about 300 W for the first electrode and the second electrode. The plasma power may have slight variations depending on the process gas mixture.

As an example, a single wafer of the first substrate 102 and the second substrate 106 may be positioned on the second electrode 406, e.g. the bottom electrode 406 of the plasma system 400 inside a plasma chamber 402. A mixture 418 of gaseous oxygen 412 and gaseous nitrogen 414 is provided to the plasma chamber through an adjustable valve system 416 that provides flow rate control for each of oxygen 412 and nitrogen 414. The RF-power at the electrodes 404, 406 adjustably forms a plasma 310 and/or 312 from the gas mixture 418. The surface of the substrate 102, 106 to be bonded (e.g., the first surface of the first substrate or the second surface of the second substrate) may be exposed to the plasma mixture 310 and/or 312 of oxygen 412 and nitrogen 414 for short time period. The time period may have a time duration in the range from about 5 s to about 120 s. The time duration may depend to best known method recipes (BKM).

Mixing of gases, e.g. oxygen 412 and nitrogen 414, in the plasma chamber 402 may be performed by controlling the flow rates of the respective gases 412, 414 forming the gas mix 418 via the valve system 416. Flow rates of oxygen 412 and nitrogen 414 may be in the range from about 5 standard cubic centimeters per minute (sccm) to about 100 sccm. At the same time, the gas pressure in the plasma chamber 402 may be controlled during the plasma activation e.g. by a suction capacity throttle valve in the vacuum pumping system (not shown). Gas pressure may be in the range from about 10 Pa to about 300 Pa. The concentration of N₂-gas to O₂-gas flow rate ratios may be in a range from about 5% to about 95 %, e.g. 10%, 15%, 20%, 25%, 30%, 50%, 75%, 95% respectively depending on the materials of the first substrate and the second substrate.

UV-light exposure under mixed gases ambient 318 may be employed to improve bond strength at room temperature and reduced annealing temperature. The exposure of UV light (e.g. having a wavelength in the range from about 150 nm to about 500 nm), e.g. using an excimer lamp may be performed under normal pressure and mixed gas N₂ / O₂ (e.g. 50% / 50% - it is to be noted that the ratio can vary depending on the circumstances) atmosphere. In this case, the mixed gases may provide oxygen and nitrogen as an agent in the reaction between a piezoelectric material of the second substrate and the material of the first substrate. Thus, activated groups, e.g. hydroxyl-groups (-OH) may be created on the surface of the first substrate and second substrate. Thus, polarity and surfaces energy of the first surface of the first substrate and of the second surface of the second substrate may be increased. The UV-light exposure may be carried out in a process chamber at atmosphere pressure.

Infrared analytics and scanning acoustic microscopy of the bonded precursor composite substrate show a bond interface, e.g. the bond layer described above, that may be generally free from detectable voids that are usually caused by thermal outgassing (also denoted as micro-voids).

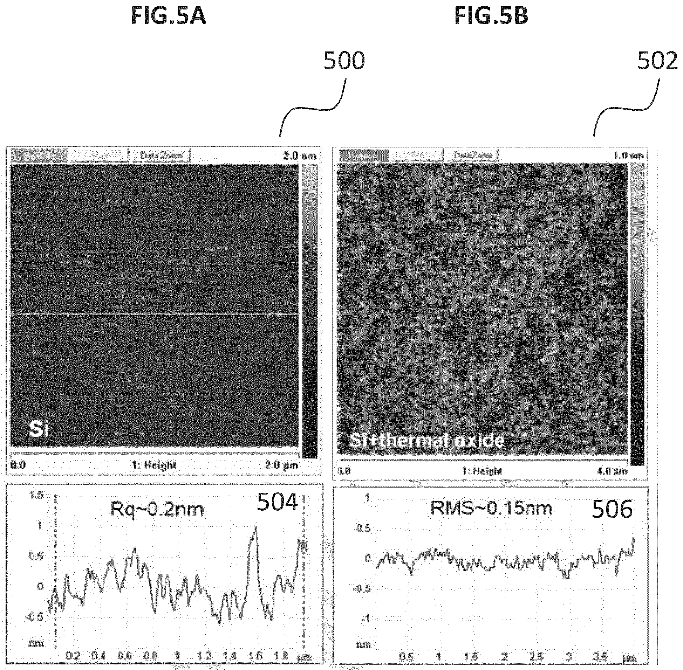

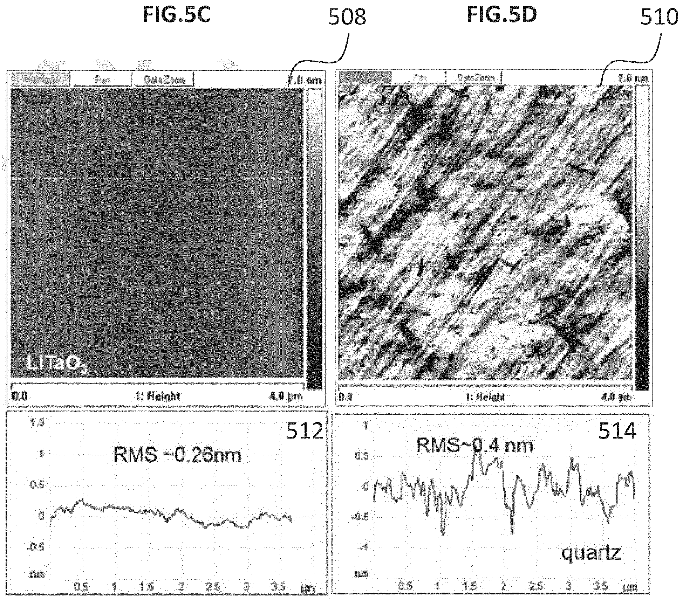

**FIG. 5A to FIG. 5D** show AFM-images 500, 502, 508, 510 including linear scan height profiles 504, 506, 512, 514 for materials indicated after mixed gas (O₂ + N₂) plasma activation 310 or 312 of **Fig. 3B****,** e.g. of surfaces of silicon (Si) illustrated in **FIG. 5A****,** thermal silicon dioxide (SiO₂) film (0.5 µm thick) on Si-wafer illustrated in **FIG. 5B****,** lithium tantalate surface illustrated in **FIG. 5C****,** and quartz surface illustrated in **FIG. 5D** after mixed gas (O₂ + N₂) plasma activation using BKM recipes per individual material.

Despite individual scratches, the RMS roughness of all substrates may be by far lower than 0.5 nm as indicated by the linear scan height profiles 504, 506, 512, 514. Smooth surfaces with a root-mean-square (RMS, Rq) roughness of about 0.5 nm or less can be preferable for bonding.

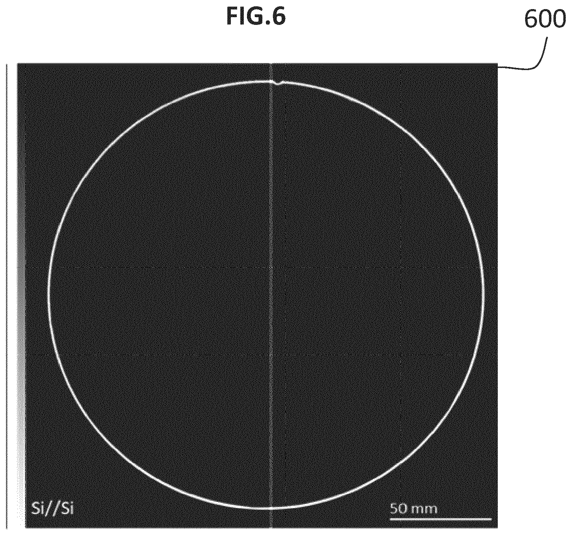

**FIG. 6** shows a scanning acoustic microscopy (SAM) image of a first example of a composite substrate. The first example includes a Si//Si wafer bonding of 0.204 m wafers. Here, Si//Si wafer bonding is performed by using plasma activation with mixed gas concentration by using BKM recipe, gas flow lower than 100 sccm, gas pressure of up to 100 Pa and plasma power of the first electrode and the second electrode of lower than 50 W. The processes prior to the bonding process (also denoted as pre-bonding processes) may be performed in vacuum at room temperature at identical conditions of a mechanical pressure of 5 kN (piston down) followed by post-bonding annealing at 300 °C for 2 hours. **FIG. 6** shows a SAM-image of a composite wafer pre-bonded in vacuum. This may be in contrast to pre-bonding at atmospheric pressure environment a high-quality bond interface without any micro-voids, or any thermal outgassing across the bond interface and the bond strength may be increased to 2.0 J/m².

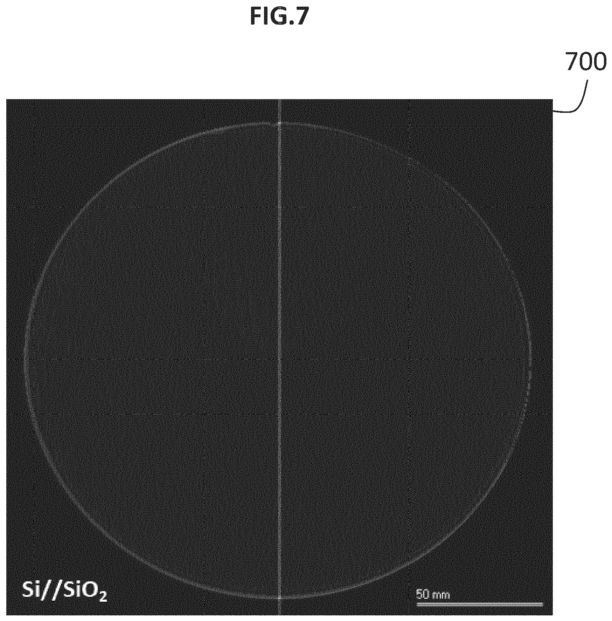

**FIG. 7** shows a scanning acoustic microscopy (SAM) image of a second example of a composite substrate. The second example includes bonded Si//SiO₂ wafers (both 0.204 m in diameter) by the admixed gas plasma activation processes using BKM recipe, plasma processing gas pressure of lower than 50 Pa, with low plasma power for the first electrode and the second electrode of less than 100 W, respectively, and pre-bonding processes in vacuum at room temperature at identical conditions followed by post-annealing at 300 °C for 2 hours. There are substantially no micro-voids or thermal outgassing across the interface for both bonded wafers (e.g. first substrate and second substrate) except for some small handling particles across edge bonding area. The bond strength may be increased to 1.6 J/m² after the post thermal annealing.

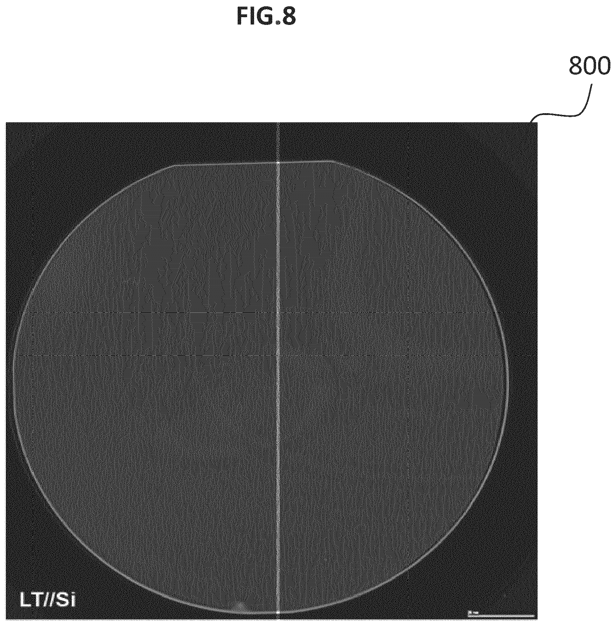

**FIG. 8** shows a scanning acoustic microscopy (SAM) image of a third example of a composite substrate. The composite substrate includes LiTaO₃ (LT) as second substrate and Si as first substrate. The shown image illustrates the composite substrate after thermal annealing at 175 °C. The composite substrate may be produced and evaluated according to the same procedure as that of example 1. The precursor composite substrate may be bonded at room temperature under 2.0 kN mechanical pressure in vacuum ambient at 0.1 Pa. The entire area of LiTaO₃ (LT) may be bonded completely. After annealing at 175 °C for 2 hours a voids-free interface can be observed. The bond strength may be 1.27 J/m² after post-annealing at 175 °C for 5 hours. The second substrate may be thinned from a thickness of about 250 µm to about 400 µm down to a thickness after thinning in the range from about 1 µm to about 250 µm, e.g. in the range from about 2 µm to about 10 µm.

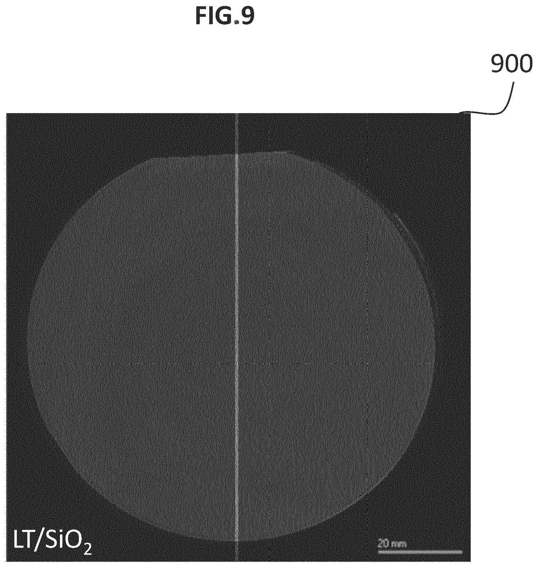

**FIG. 9** shows a scanning acoustic microscopy (SAM) image of a fourth example of a composite substrate 900. The composite substrate includes an LT wafer as a second substrate to a silicon wafer as a first substrate with thermal oxide (e.g. 500 nm thickness) after thermal annealing 150 °C. In the fourth example, the bonded 0.153 m wafers of the first substrate and the second substrate may be produced and evaluated according to the same procedure as that of example 2. Here, the material of piezoelectric single crystal substrate (second substrate) may be lithium tantalate (LT) and the Si-handle wafer may be covered with 500 nm of thermal oxide (first substrate) to prepare them for using as RF-velocity layer as supporting material. **FIG. 9** shows the Scanning Acoustic Microscopy (SAM)-image of bonded interface of LT//SiO₂ bonding at room temperature (RT) and after thermal annealing at 150 °C for 2 hours. The entire area of the wafer pair may be completely bonded. Measured bond strength may be 1.1 J/m². From inspection by SAM-measurement of this bonded interface many small micro bubbles can be observed and the same occurs when thermal oxide wafer bonding is performed in vacuum. However, it can be observed that there is no outgassing and no gas bubbles after thermal annealing at 150 °C for 5 hours in cases of Si-wafer with sputter deposited oxide (100 nm - 1000 nm thickness). The second substrate may be thinned from a thickness of about 250 µm to about 400 µm down to a thickness after thinning in the range from about 1 µm to about 250 µm, e.g. in the range from about 2 µm to about 10 µm.

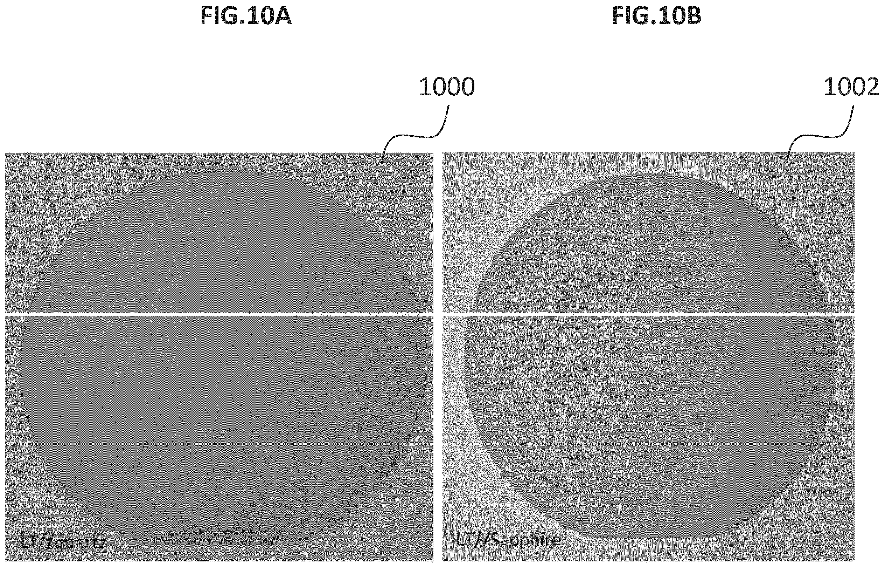

**FIG. 10A** and **FIG. 10B** show infrared (IR) transmission-images of bonded composite substrates including a LiTaO₃ wafer as second substrate bonded to a quartz wafer **(****FIG. 10A****)** and a sapphire wafer **(****FIG. 10B****),** respectively as first substrate. The bonded 0.102 m wafers may be produced and evaluated according to the same procedure as that of the example 3. In the present example the piezoelectric material of the second substrate may be a 0.204 m single crystal lithium tantalate (LT) wafer, and the first substrate may be a 0.204 m quartz (fused silica) and a 0.204 m sapphire (Al₂O₃), respectively. The composite substrates have been pre-bonded at room temperature under 2 kN mechanical pressure in vacuum ambient followed by thermal annealing < 200 °C for 5 hours. Bonded composite substrates show high bond quality, free from macro-voids and thermal micro-voids formed before and after annealing. The bond strength may be 1.3 J/m². The second substrate may be thinned from a thickness of about 250 µm to about 400 µm down to a thickness after thinning in the range from about 1 µm to about 250 µm, e.g. in the range from about 2 µm to about 10 µm.

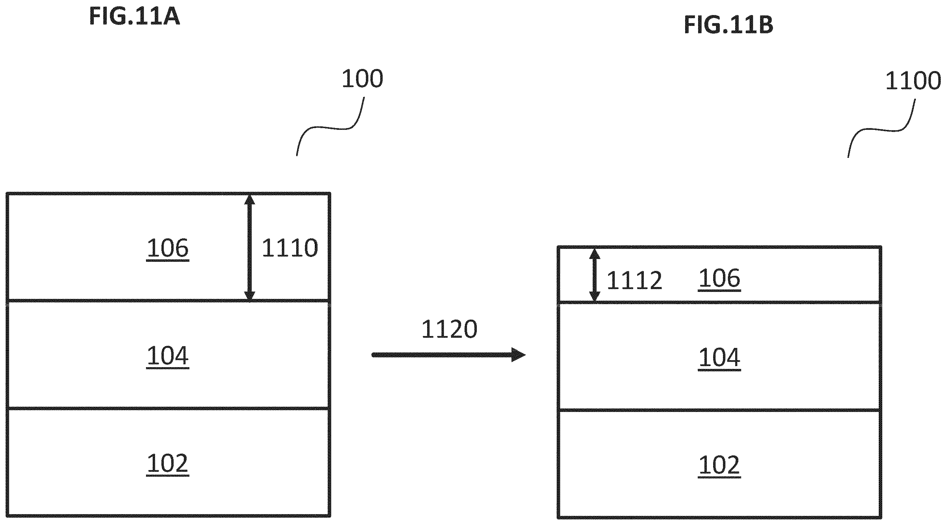

**FIG. 11A** and **FIG. 11B** illustrate a schematic diagram of a method to produce a piezoelectric material to SiC wafer composite substrate before a thinning and polishing process 1120 **(****FIG. 11A****)** Here, the second substrate 106 has a first thickness 1110. The thickness 1110 of the second substrate 106 may be reduced to a second thickness 1112, as illustrated in **FIG. 11B****,** by a thinning and polishing process 1120. The second thickness 1112 may be in the range from about 1 µm to about 250 µm, e.g. in the range from about 2 µm to about 10 µm. The thinned composite substrate 1100 may include piezoelectric material to silicon carbide (SiC) which bonded surface may include a Si-face. The wafer bonding may be produced and evaluated according to the same procedure as that of the example 3 described above. However, the materials of the piezoelectric single crystal substrate may include lithium tantalate (LT) single crystal and the material of first substrate 102 may include a 4H-SiC substrate.

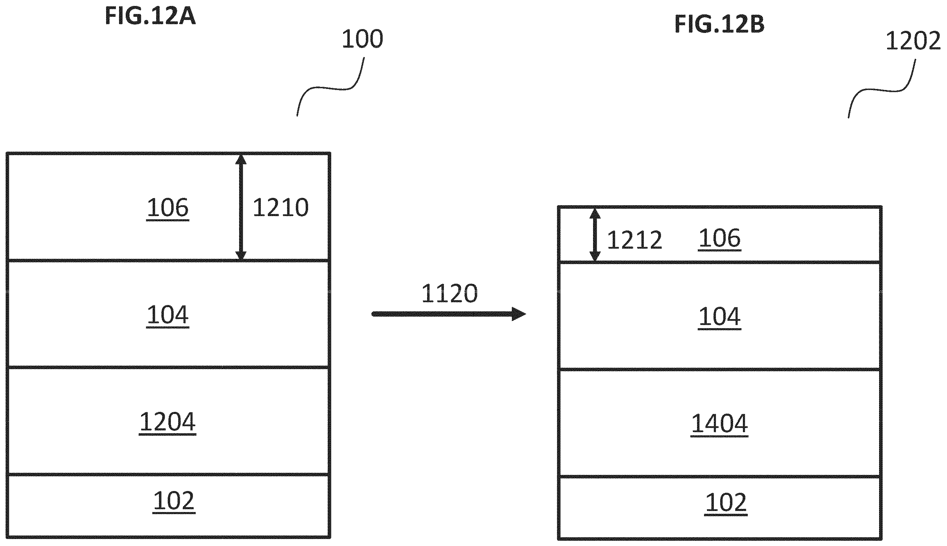

**FIG. 12A** and **FIG.12B** illustrates a schematic diagram of a method to produce a piezoelectric material to thin film c-BN or diamond wafer composite substrate before a thinning and polishing process 1120 **(****FIG. 12A****)** (e.g. including a first substrate made of silicon and the thin layer of c-BN or diamond) Here, the second substrate 106 has a first thickness 1210. The thickness 1210 of the second substrate 106 may be reduced to a second thickness 1212, as illustrated in **FIG. 12B****,** by means of a thinning and polishing process 1120. The second thickness 1212 may be in the range from about 1 µm to about 250 µm, e.g. in the range from about 2 µm to about 10 µm.

The composite substrate 100 may include a piezoelectric material of the second substrate 106 bonded to the first substrate having in addition a c-BN layer 1204 or a thin diamond layer 1204 (e.g. thickness below 1 µm), for example. In other words, the composite substrate 100 may include a thin film of c-boron nitride layer 1204 or diamond layer 1204. The c-BN layer 1204 can also be deposited by using a physical vapor deposition (PVD)-method, wherein the c-BN layer 1204 may be deposited by radio-frequency magnetron sputtering (RFMS). A c-BN film of about 1.1 µm thickness may be deposited on the first substrate 102, e.g. a Si-substrate, with very smooth surface. The composite substrate 100 may be produced and evaluated according to the same procedure as that of the example 2, the mixed gas plasma may be activated based on a high plasma power in nitrogen / oxygen gas mixture at a ratio of 1:1 (O₂ : N₂) with a total gas flow rate of lower than 50 sccm. The bonding layer 104 may be very uniform and may have a thickness in the range of 10.0 nm. The bonding layer 104 may include a large portion of amorphous nitride from the mixed gas activation process and mixed gas UV surface modification to improve bond strength in the range of 0.8 J/m² without using any post-bonding heating. Here, post-thermal annealing at temperature higher than 200°C may be used to enhance the bond strength up to 1.8 J/m².

The diamond layer 1204 can also be deposited on silicon substrate 102 by a PVD method. The diamond film 1204 may have a layer thickness of about up to 2.0 µm. The diamond layer 1204 may be polished using ion beam trimming to achieve a surface roughness (RMS) lower than 0.5 nm. The wafer bonding may be produced and evaluated according to the same procedure as that of the example illustrated above. The mixed gas plasma may be activated based on high plasma power and for long-time plasma activation in the nitrogen / oxygen gas mixture at a ratio of 1:1 (O₂ : N₂) with a total gas flow rate of lower than 75 sccm and long-time lower than 120 s by mixed gas UV surface modification. The bonding layer 104 may be highly uniform and may have a thickness of about up to 15.0 nm. The bonding layer 104 may include a large portion of amorphous nitride according to mixed gas plasma activation of the first surface and the second surface to be bonded to improve bond strength without using any heating. Here, post-thermal annealing at temperature higher than 200°C may be used to enhance the bond strength.

Illustratively, lithium tantalate and lithium niobate single crystal substrate may be used for an acoustic wave filter that may have a low thermal conduction. A surface activation process is provided by using mixed gas (O₂+N₂) plasma and UV-surface modification under mixed gas atmosphere (O₂+N₂) that can exhibit excellent bonding layer between bonded wafers of a composite substrate and a method of manufacturing a thin film bonded wafer. The plasma activation method and the UV surface modification method may be used in the case that a first substrate such as silicon (Si), silicon oxide (SiO₂), Sapphire (Al₂O₃), silicon carbide (SiC), cubic boron nitride (c-BN) and diamond is directly bonded to a second substrate such as lithium niobate (LN), lithium tantalate (LT), Quartz (SiO₂).

The plasma surface activation process may be used for bonding of lithium tantalate (LT) and lithium niobate (LN) surfaces to a variety of substrates.

The bonding method may be used to bond dissimilar materials of LN-wafers and LT-wafers to Si, SiO₂, sapphire, c-BN and SiC-substrates (e.g. having a diameter of 0.051 m, 0.102 m, 0.153 m and 0.204 m) at room temperature in vacuum ambient.

The mixed gas plasma process may be used for surface activation of all second substrates and first substrates with plasma power for the first electrode of the plasma system from 10 W to 150 W and with plasma power for the second electrode of the plasma system in the range from 10 W to 150 W.

The mixed gas plasma process for surfaces activation may be used for all second substrates and first substrates with plasma duration (time) between 5 s to 180 s.

The mixed gas plasma process for surface activation of second substrates and first substrates may be used with gas pressure plasma between 10 Pa and 200 Pa.

The mixed gas plasma process for surfaces activation of all second substrates and first substrates may be used with post-thermal annealing under forming gas atmospheric between 100 °C to 200 °C.

The method provides composite substrates having a high-quality bond interface free of macro- and micro-voids and strong bonding, free of thermal outgassing and without damage of surfaces structures.

The composite substrate may have excellent thermal stability against high temperatures up to 250 °C. Thus, an efficiently fabricated thin film surface acoustic wave (TF-SAW) device may be provided.

The method may provide bonding for almost the entire wafer of the first substrate and the second substrate with different sizes of wafers. In other words, the method for forming a composite substrate may include a plasma activation process which in turn may include exposing a first surface of a first substrate and a second surface of a second substrate, respectively, in a plasma system, wherein the plasma system may be a radiofrequency system having a plasma between a first electrode and a second electrode that may be separately powered and the plasma may be a mixed gas plasma of oxygen and nitrogen at a first ambient pressure that may be below an atmospheric pressure; a surface modification process may include exposing of the plasma activated first surface and the plasma activated second surface to an ultraviolet radiation in an atmosphere of oxygen and nitrogen at atmospheric pressure; a process of forming a precursor composite substrate by placing the first surface of the first substrate on the second surface of the second substrate, a process of bonding the first substrate to the second substrate by applying a mechanical load on the precursor composite substrate at a second ambient pressure; and a process of thermally annealing the bonded precursor composite substrate. The first substrate may be a wafer configured to support the second substrate that may be single crystal and non-crystal, and wherein the second substrate may be a piezoelectric material wafer.

The second ambient pressure may be an atmospheric pressure. The second ambient pressure may be a vacuum pressure in a range from about 0.1 Pa to about 10⁻³ Pa.

The method may further include a polishing of the first surface and the second surface such that the first surface and the second surface have a root-mean-square roughness of less than 0.5 nm, respectively.

The method may include a plasma power for the first electrode in a range of about 10 W to about 300 W. The method may include a plasma power for the second electrode in a range of about 10 W to about 300 W. The plasma activation time periods of one or more time periods may be of the time periods of about 5 s to about 180 s.

The mixed gas plasma may include a gas flow ratio of a nitrogen flow rate to oxygen flow rate in a range from about 0.01 to about 0.99. The gas flow of the mixed gas plasma may be in a range from about 5 sccm to about 100 sccm. The first ambient pressure may be in a range of about 10 Pa to about 200 Pa. The method may further include a rinsing process which in turn may include a megasonic assisted deionized (DI) water rinsing and drying of the plasma activated first surface and second surface. The surface modification process may include the rinsing process. The exposition to the ultraviolet radiation may be performed before the rinsing process. Alternatively, the exposition to the ultraviolet radiation may be performed after the rinsing process.

The ultraviolet radiation may include electromagnetic radiation having a wavelength in a wavelength range from about 150 nm to about 500 nm.

During ultraviolet irradiation, the temperatures of the first surface and the second surface may be lower than about 100 °C.

The mechanical load may include a piston down mechanical pressure of up to 5 kN.

The thermal annealing process may include a temperature of the bonded precursor composite substrate of one or more temperature periods at temperatures of 100 °C, 120 °C, 150 °C, 175 °C, 190 °C and 250 °C.

The piezoelectric material wafer of the second substrate may include a piezoelectric single crystal selected from the group may include of lithium niobate (LN), lithium tantalate (LT), quartz and any combination thereof.

The method may further include a third substrate bonded to the first substrate according in addition to the second substrate, wherein the third substrate may be a piezoelectric material wafer dissimilar to the piezoelectric material of the second substrate. The piezoelectric material wafer of the third substrate may include a piezoelectric single crystal selected from the group may include of lithium niobate (LN), lithium tantalate (LT), quartz and any combination thereof.

The wafer of the first substrate may include a material substrate selected from the group may include silicon (Si), silicon oxide (SiO₂), silicon carbide (SiC), cubic boron nitride (c-BN), sapphire, diamond and any combination thereof.

The term "as an example" is used herein to mean "serving as an example, instance, or illustration". Any aspect or design described herein as "as an example" is not necessarily to be construed as preferred or advantageous over other aspects or designs. The word "exemplary" is used herein to mean "serving as an example, instance, or illustration." Any example or design described herein as "exemplary" is not necessarily to be construed as preferred or advantageous over other examples or designs.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in plural form that does not expressly state "plurality" or "multiple" likewise refers to a quantity equal to or greater than one.

The terms "processor" or "controller" as, for example, used herein may be understood as any kind of technological entity that allows handling of data. The data may be handled according to one or more specific functions that the processor or controller execute. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

The term "connected" can be understood in the sense of a (e.g. mechanical and/or electrical), e.g. direct or indirect, connection and/or interaction. For example, several elements can be connected together mechanically such that they are physically retained (e.g., a plug connected to a socket) and electrically such that they have an electrically conductive path (e.g., signal paths exist along a communicative chain). While the above descriptions and connected figures may depict electronic device components as separate elements, skilled persons will appreciate the various possibilities to combine or integrate discrete elements into a single element. Such may include combining two or more circuits from a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc. Also, it is appreciated that particular implementations of hardware and/or software components are merely illustrative, and other combinations of hardware and/or software that perform the methods described herein are within the scope of the disclosure.

It is appreciated that implementations of methods detailed herein are exemplary in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

While the disclosure has been particularly shown and described with reference to specific embodiments, it should be understood by those skilled in the art that various changes in form and detail may be made therein without departing from the scope of the disclosure as defined by the appended claims.

## Claims

1. A method for forming a composite substrate, the method comprising an oxygen and nitrogen mixed gas plasma activation process comprising exposing a surface of a wafer and a surface of a piezoelectric material wafer in a plasma system;
exposing the plasma activated surface of the wafer and the plasma activated surface of the piezoelectric material wafer to an ultraviolet radiation in an atmosphere of oxygen and nitrogen;
placing the surface of the wafer on the surface of the piezoelectric material wafer, applying a mechanical load on the wafer and the piezoelectric material wafer; and
thermally annealing the bonded wafer and piezoelectric material wafer;
wherein the wafer is configured to support the piezoelectric material wafer.

2. The method of claim 1, further comprising:
a polishing of the surface of the wafer and the surface of the piezoelectric material wafer such that the surface of the wafer and the surface of the piezoelectric material wafer have a root-mean-square roughness of less than 0.5 nm, respectively.

3. The method of any one of claims 1 to 2, wherein the atmosphere comprises a gas flow ratio of a nitrogen flow rate to oxygen flow rate in a range of 0.01 and 0.99.

4. The method of any one of claims 1 to 3, wherein the gas flow of the atmosphere is in a range from about 5 sccm to 100 sccm.

5. The method of any one of claims 1 to 4, wherein the plasma activation comprises an ambient pressure in a range of about 10 Pa and 200 Pa.

6. The method of any one of claims 1 to 5, further comprising a rinsing process comprising a megasonic assisted deionized (DI) water rinsing and drying of the plasma activated surface of the wafer and the plasma activated surface of the piezoelectric material wafer.

7. The method of claim 6, wherein the surface modification process comprises the rinsing process.

8. The method of claim 6 or 7, wherein the exposition to the ultraviolet radiation is performed before the rinsing process.

9. The method of claim 6 or 7, wherein the exposition to the ultraviolet radiation is performed after the rinsing process.

10. The method of any one of claims 1 to 9, wherein the ultra violet radiation comprises electromagnetic radiation having a wavelength in a wavelength range from about 150 nm to 500 nm.

11. The method of any one of claims 1 to 10, wherein, during ultra violet irradiation, the temperatures of the surface of the wafer and the surface of the piezoelectric material wafer are lower than 100 °C.

12. The method of any one of claims 1 to 11, wherein the mechanical load comprises a piston down mechanical pressure of up to 5 kN.

13. The method of any one of claims 1 to 12, wherein the piezoelectric material wafer comprises a piezoelectric single crystal selected from the group consisting of lithium niobate (LN), lithium tantalate (LT), quartz and any combination thereof.

14. The method of any one of claims 1 to 13, further comprising bonding a further piezoelectric material wafer to the wafer, wherein the piezoelectric material of the further piezoelectric material wafer is dissimilar to the piezoelectric material of the piezoelectric material wafer.

15. The method of claim 14, wherein the piezoelectric material of the further piezoelectric material wafer comprises a piezoelectric single crystal selected from the group consisting of lithium niobate (LN), lithium tantalate (LT), quartz and any combination thereof.

16. The method of any one of claims 1 to 15, wherein the wafer comprises a material selected from the group consisting of silicon (Si), silicon oxide (SiO₂), silicon carbide (SiC), cubic boron nitride (c-BN), sapphire, diamond and any combination thereof.

## Patentansprüche

1. Verfahren zum Herstellen eines Verbundsubstrats, wobei das Verfahren umfasst:
einen Sauerstoff- und Stickstoff-Gemischgas-Plasmaaktivierungsprozess, umfassend das Aussetzen einer Oberfläche eines Wafers und einer Oberfläche eines piezoelektrischen Materialwafers in einem Plasmasystem;
das Aussetzen der plasmaaktivierten Oberfläche des Wafers und der plasmaaktivierten Oberfläche des piezoelektrischen Materialwafers einer ultravioletten Strahlung in einer Atmosphäre aus Sauerstoff und Stickstoff;
das Aufeinanderlegen der Oberfläche des Wafers auf die Oberfläche des piezoelektrischen Materialwafers, das Anlegen einer mechanischen Last auf den Wafer und den piezoelektrischen Materialwafer, sowie das thermische Anlassen des gebondeten Wafers und des piezoelektrischen Materialwafers;
wobei der Wafer dazu ausgebildet ist, den piezoelektrischen Materialwafer zu tragen.

2. Verfahren nach Anspruch 1, ferner umfassend:
ein Polieren der Oberfläche des Wafers und der Oberfläche des piezoelektrischen Materialwafers, sodass die Oberfläche des Wafers und die Oberfläche des piezoelektrischen Materialwafers jeweils eine quadratische Mittenrauhigkeit (root-mean-square roughness) von weniger als 0,5 nm aufweisen.

3. Verfahren nach einem der Ansprüche 1 bis 2, wobei die Atmosphäre ein Gasströmungsverhältnis der Stickstoff-Durchflussrate zur Sauerstoff-Durchflussrate im Bereich von 0,01 bis 0,99 umfasst.

4. Verfahren nach einem der Ansprüche 1 bis 3, wobei die Gasströmung der Atmosphäre im Bereich von etwa 5 sccm bis 100 sccm liegt.

5. Verfahren nach einem der Ansprüche 1 bis 4, wobei die Plasmaaktivierung einen Umgebungsdruck im Bereich von etwa 0,1 mbar bis 2,0 mbar umfasst.

6. Verfahren nach einem der Ansprüche 1 bis 5, ferner umfassend einen Spülprozess, umfassend ein megasonisch unterstütztes Spülen mit deionisiertem (DI-) Wasser und Trocknen der plasmaaktivierten Oberfläche des Wafers und der plasmaaktivierten Oberfläche des piezoelektrischen Materialwafers.

7. Verfahren nach Anspruch 6, wobei der Oberflächenmodifikationsprozess den Spülprozess umfasst.

8. Verfahren nach Anspruch 6 oder 7, wobei das Aussetzen gegenüber der ultravioletten Strahlung vor dem Spülprozess durchgeführt wird.

9. Verfahren nach Anspruch 6 oder 7, wobei das Aussetzen gegenüber der ultravioletten Strahlung nach dem Spülprozess durchgeführt wird.

10. Verfahren nach einem der Ansprüche 1 bis 9, wobei die ultraviolette Strahlung elektromagnetische Strahlung mit einer Wellenlänge im Bereich von etwa 150 nm bis 500 nm umfasst.

11. Verfahren nach einem der Ansprüche 1 bis 10, wobei während der ultravioletten Bestrahlung die Temperaturen der Oberfläche des Wafers und der Oberfläche des piezoelektrischen Materialwafers unter 100 °C liegen.

12. Verfahren nach einem der Ansprüche 1 bis 11, wobei die mechanische Last einen nach unten gerichteten Kolbendruck von bis zu 5 kN umfasst.

13. Verfahren nach einem der Ansprüche 1 bis 12, wobei der piezoelektrische Materialwafer einen piezoelektrischen Einkristall umfasst, ausgewählt aus der Gruppe bestehend aus Lithiumniobat (LN), Lithiumtantalat (LT), Quarz und beliebigen Kombinationen davon.

14. Verfahren nach einem der Ansprüche 1 bis 13, ferner umfassend das Bonden eines weiteren piezoelektrischen Materialwafers an den Wafer, wobei das piezoelektrische Material des weiteren piezoelektrischen Materialwafers sich von dem piezoelektrischen Material des piezoelektrischen Materialwafers unterscheidet.

15. Verfahren nach Anspruch 14, wobei das piezoelektrische Material des weiteren piezoelektrischen Materialwafers einen piezoelektrischen Einkristall umfasst, ausgewählt aus der Gruppe bestehend aus Lithiumniobat (LN), Lithiumtantalat (LT), Quarz und beliebigen Kombinationen davon.

16. Verfahren nach einem der Ansprüche 1 bis 15, wobei der Wafer ein Material umfasst, ausgewählt aus der Gruppe bestehend aus Silizium (Si), Siliziumoxid (SiO2), Siliziumkarbid (SiC), kubischem Bornitrid (c-BN), Saphir, Diamant und beliebigen Kombinationen davon.

## Revendications

1. Procédé de formation d'un substrat composite, le procédé comprenant :
un procédé d'activation par plasma d'un gaz mixte oxygène et azote comprenant l'exposition d'une surface d'une tranche et d'une surface d'une tranche de matériau piézoélectrique dans un système plasma ;
l'exposition de la surface activée par plasma de la tranche et de la surface activée par plasma de la tranche de matériau piézoélectrique à un rayonnement ultraviolet dans une atmosphère d'oxygène et d'azote ;
la disposition de la surface de la tranche sur la surface de la tranche de matériau piézoélectrique, l'application d'une charge mécanique sur la tranche et la tranche de matériau piézoélectrique, et un recuit thermique de la tranche et de la tranche de matériau piézoélectrique ainsi liées ;
la tranche étant configurée pour supporter la tranche de matériau piézoélectrique.

2. Procédé selon la revendication 1, comprenant en outre :
un polissage de la surface de la tranche et de la surface de la tranche de matériau piézoélectrique de telle sorte que la surface de la tranche et la surface de la tranche de matériau piézoélectrique présentent respectivement une rugosité quadratique moyenne (root-mean-square roughness) inférieure à 0,5 nm.

3. Procédé selon l'une quelconque des revendications 1 à 2, dans lequel l'atmosphère comprend un rapport de débit gazeux entre un débit d'azote et un débit d'oxygène dans un intervalle de 0,01 à 0,99.

4. Procédé selon l'une quelconque des revendications 1 à 3, dans lequel l'écoulement gazeux de l'atmosphère se situe dans un intervalle d'environ 5 sccm à 100 sccm.

5. Procédé selon l'une quelconque des revendications 1 à 4, dans lequel l'activation par plasma comprend une pression ambiante dans un intervalle d'environ 0,1 mbar à 2,0 mbar.

6. Procédé selon l'une quelconque des revendications 1 à 5, comprenant en outre une étape de rinçage comprenant un rinçage à l'eau déionisée (DI) assisté par mégason et un séchage de la surface activée par plasma de la tranche et de la surface activée par plasma de la tranche de matériau piézoélectrique.

7. Procédé selon la revendication 6, dans lequel le procédé de modification de surface comprend l'étape de rinçage.

8. Procédé selon la revendication 6 ou 7, dans lequel l'exposition au rayonnement ultraviolet est réalisée avant l'étape de rinçage.

9. Procédé selon la revendication 6 ou 7, dans lequel l'exposition au rayonnement ultraviolet est réalisée après l'étape de rinçage.

10. Procédé selon l'une quelconque des revendications 1 à 9, dans lequel le rayonnement ultraviolet comprend un rayonnement électromagnétique ayant une longueur d'onde dans un intervalle d'environ 150 nm à 500 nm.

11. Procédé selon l'une quelconque des revendications 1 à 10, dans lequel, pendant l'irradiation ultraviolette, les températures de la surface de la tranche et de la surface de la tranche de matériau piézoélectrique sont inférieures à 100 °C.

12. Procédé selon l'une quelconque des revendications 1 à 11, dans lequel la charge mécanique comprend une pression mécanique de piston vers le bas allant jusqu'à 5 kN.

13. Procédé selon l'une quelconque des revendications 1 à 12, dans lequel la tranche de matériau piézoélectrique comprend un monocristal piézoélectrique choisi dans le groupe constitué de niobate de lithium (LN), tantalate de lithium (LT), quartz et de toute combinaison de ceux-ci.

14. Procédé selon l'une quelconque des revendications 1 à 13, comprenant en outre le collage d'une autre tranche de matériau piézoélectrique à la tranche, le matériau piézoélectrique de l'autre tranche de matériau piézoélectrique étant différent du matériau piézoélectrique de la tranche de matériau piézoélectrique.

15. Procédé selon la revendication 14, dans lequel le matériau piézoélectrique de l'autre tranche de matériau piézoélectrique comprend un monocristal piézoélectrique choisi dans le groupe constitué de niobate de lithium (LN), tantalate de lithium (LT), quartz et de toute combinaison de ceux-ci.

16. Procédé selon l'une quelconque des revendications 1 à 15, dans lequel la tranche comprend un matériau choisi dans le groupe constitué de silicium (Si), oxyde de silicium (SiO2), carbure de silicium (SiC), nitrure de bore cubique (c-BN), saphir, diamant et de toute combinaison de ceux-ci.
